## Europäisches Patentamt
## European Patent Office
## Office européen des brevets

(11) Veröffentlichungsnummer: **0 262 365**
**A2**

# EUROPÄISCHE PATENTANMELDUNG

(21) Anmeldenummer 87111899.8

(51) Int Cl.⁴ **G01R 31/28**

(22) Anmeldetag: 17.08.87

(30) Priorität: 30.09.86 DE 3633235

(43) Veröffentlichungstag der Anmeldung:
06.04.88 Patentblatt 88/14

(84) Benannte Vertragsstaaten:
**DE FR GB IT NL**

(71) Anmelder: **Siemens Aktiengesellschaft Berlin und München**
**Wittelsbacherplatz 2**
**D-8000 München 2(DE)**

(72) Erfinder: **Feuerbaum, Hans-Peter, Dr., Dipl.-Phys.**
**Arno-Assmann-Strasse 14**
**D-8000 München 83(DE)**
Erfinder: **Papp, Alfred, Dr., Dipl.-Ing.**
**Winternitzstrasse 6**
**D-8000 München 83(DE)**
Erfinder: **Otto, Johann, Dipl.-Ing. FH**
**Pater-Hammerschmidt-Strasse 4**
**D-8170 Bad Tölz(DE)**

(54) **Spektrometer-Detektoranordnung für quantitative Potentialmessungen.**

(57) Die erfindungsgemäße Spektrometer-Detektoranordnung besteht aus einem elektrostatischen Gegenfeldspektrometer (SP) und einem unmittelbar oberhalb des Spektrometers (SP) symmetrisch zur Strahlachse (OA) angeordneten Detektor (DT). der eine ebene, auf positivem Potential liegende Gitterelektrode (G) einen Szintillator (SZ) und eine großflächige, vorzugsweise ringförmig ausgebildete Photodiode (PD) aufweist. Das Gegenfeldspektrometer besteht aus zwei halbkugelförmigen Gitterelektroden (K1, K2) und einer mit einem Widerstandsfilm (WF) versehenen ringförmigen Isolatorscheibe (IS) die den Raumbereich zwischen den Elektroden (K1. K2) probenseitig abschließt

EP 0 262 365 A2

## Spektrometer-Detektoranordnung für quantitative Potentialmessungen

Die Erfindung betrifft eine Spektrometer-Detektoranordnung für quantitative Potentialmessungen nach dem Oberbegriff des Patentanspruchs 1

Die Funktionsweise mikroelektronischer Bauelemente wird üblicherweise in rechnergesteuerten Testsystemen durch Analyse der an den Ausgängen der Schaltung gemessenen Signale überprüft Die so durchgeführten Tests sind allerdings in den meisten Fällen unvollständig, da fehlerhafte Bausteinkomponenten nur sehr schwer innerhalb der hochkomplexen Strukturen lokalisiert werden können Deshalb ist man insbesondere im Bereich der Entwicklung und Fertigung mikroelektronischer Bauelemente gezwungen zusätzliche Messungen im Innern der Schaltungen durchzuführen. Besonders aufschlußreiche Hinweise zur Lokalisierung fehlerhafter Bausteinkomponenten erhält man hierbei durch Messungen des zeitlichen Signalverlaufes an internen Knotenpunkten und Leiterbahnen.

Quantitative Potentialmessungen werden gegenwärtig mit Hilfe modifizierter Rasterelektronenmikroskope durchgeführt, in denen man die vom Potential des Meßpunktes abhängige Verschiebung der Energieverteilung der von einem primären Elektronenstrahl ausgelösten Sekundärelektronen mit einer Spektrometer-Detektoranordnung bestimmt. Eine solche Spektrometer-Detektoranordnung ist beispielsweise aus der Veröffentlichung von H. P. Feuerbaum "VLSI testing using the electron probe" SEM/1979/I Seite 285-296 bekannt. Die bekannte Anordnung besteht im wesentlichen aus einer Absaugelektrode, einer ebenen Gegenfeldelektrode und einer Ablenkeinheit zur Beschleunigung der Sekundärelektronen in Richtung eines seitlich oberhalb der Probe angeordneten Detektors. Aufgrund des unsymmetrischen Aufbaus dieser Anordnung kann man allerdings nur einen Teil der Sekundärelektronen mit Energien oberhalb der im Spektrometer aufgebauten Potentialbarriere nachweisen, da insbesondere die auf achsenfernen Bahnen laufenden Teilchen nur schwach abgelenkt werden

Der Erfindung liegt die Aufgabe zugrunde, eine Spektrometer-Detektoranordnung der eingangs genannten Art anzugeben, mit der nahezu alle Sekundärelektronen mit kinetischen Energien oberhalb der im Spektrometer aufgebauten Potentialbarriere nachgewiesen werden Es soll insbesondere ein vom Emissionswinkel der Sekundärelektronen unabhängiger Nachweis gewährleistet sein.

Diese Aufgabe wird erfindungsgemäß durch eine Spektrometer-Detektoranordnung der eingangs genannten Art gelöst, welche die kennzeichnenden Merkmale des Patentanspruchs 1 aufweist

Der mit der erfindungsgemäßen Spektrometer-Detektoranordnung erzielbare Vorteil besteht insbesondere darin, daß das Signal-Rausch-Verhältnis und damit die Auflösung bei quantitativen Potentialmessungen deutlich gesteigert werden kann

Die Ansprüche 2 bis 6 sind auf bevorzugte Ausgestaltungen und Weiterbildungen der Erfindung gerichtet

Die Erfindung wird nachfolgend anhand der Zeichnung erläutert, in der ein bevorzugtes Ausführungsbeispiel einer erfindungsgemäßen Spektrometer-Detektoranordnung dargestellt ist.

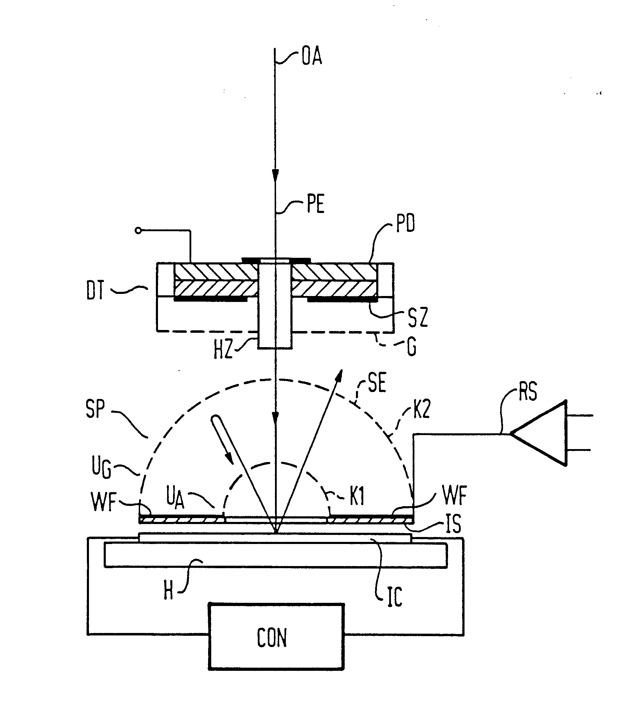

Trifft ein primärer Elektronenstrahl auf eine Probe, so werden aufgrund der Wechselwirkung der Primärteilchen mit der Festkörpersubstanz Sekundärelektronen emittiert, deren Energie-und Winkelverteilung u. a. von der im Wechselwirkungsbereich vorliegenden chemisch-physikalischen Zusammensetzung, der Oberflächenstruktur und der auf der Probe vorhandenen Potentialverteilung beeinflußt wird. Von besonderer Bedeutung für die Überprüfung der Funktionsweise mikroelektronischer Bauelemente ist hierbei der als Potentialkontrast bezeichnete und mittels einer Spektrometer-Detektoranordnung quantitativ erfaßbare Einfluß elektrischer Felder auf die Energieverteilung der emittierten Sekundär-elektronen (siehe beispielsweise die eingangs zitierte Veröffentlichung von H. P. Feuerbaum). Das in der Zeichnung dargestellte elektrostatische Gegenfeldspektrometer zur Bestimmung der vom Probenpotential abhängigen Verschiebung der Energieverteilung der von einem primären Elektronenstrahl PE ausgelösten Sekundärelektronen SE besteht im wesentlichen aus zwei auf unterschiedlichem Potential $U_A$ bzw $U_G$ liegenden Elektroden K1 und K2 und einer mit einem Widerstandsfilm WF bedampften Isolatorscheibe IS, die den Raum zwischen den halbkugelförmigen Elektroden K1 bzw K2 probenseitig abschließt Diese Elektroden sind vorzugsweise netzartig ausgebildet und erlauben den Durchtritt der entlang der Strahlachse OA in das Spektrometer SP eintretenden Primärelektronen PE Den primären Elektronenstrahl PE erzeugt man vorzugsweise in einem in Fig 1 nicht dargestellten Elektronenstrahlmeßgerät, dessen elektronenoptische Säule im wesentlichen aus einer Elektronenkanone, einem Strahlaustastsystem, einer Ablenkeinheit und einem Linsensystem zur Fokussierung des Strahls auf einen nicht näher bezeichneten Punkt der Probe IC besteht. Als Probe IC ist vorzugsweise eine auf einer Halterung H angeordnete und relativ zum Primärelektronenstrahl PE ausgerichtete hoch integrierte Schaltung vorgesehen, in die man geeignete Testprogramme über eine Ansteuerung CON einspeist Entsprechend der Schaltungsstruktur der Probe IC treten dann während des Testzyklus charakteristische, den jeweiligen Betriebszustand definierende Signale an Knotenpunkten und Leiterbahnen auf, deren Zeitverhalten beispielsweise mit Hilfe eines Sampling-Verfahrens aufgezeichnet und mit den aus Simulationsrechnungen gewonnenen Signalverläufen verglichen werden kann

Die vom primären Elektronenstrahl PE an einem Meßpunkt ausgelösten und in einen großen Raumwinkelbereich emittierten Sekundärelektronen SE durchlaufen die lokalen Felder an der Probenoberfläche und gelangen in das mit Hilfe der auf unterschiedlichem Potential liegenden halbkugelförmigen Gitterelektroden K1 und K2 erzeugte Gegenfeld. Die Höhe der im Spektrometer SP aufgebauten Potentialbarriere, die man über die an der Elektrode K2 anliegende Spannung $U_G$ einstellt und die den im Detektor DT nachweisbaren Sekundärelektronenstrom begrenzt ist hierbei so gewählt, daß die von lokalen elektrischen Feldern an der Probenoberfläche stark beeinflußten niederenergetischen Sekundärelektronen SE nicht zum Meßsignal beitragen. Die äußere halbkugelförmige Elektrode K2 wird deshalb üblicherweise mit Spannungen $U_G$ zwischen etwa + 15 Volt und -15 Volt beaufschlagt während die innere Elektrode K1 auf Erdpotential oder niedrigem positiven Potential $U_A$ liegt. Um eine über einen großen Winkelbereich kugelsymmetrische Feldverteilung innerhalb des Spektrometers SP aufzubauen, wird der Raum zwischen äußerer und innerer Elektrode K1 und K2 probenseitig von einer ringförmigen Isolatorscheibe IS abgeschlossen, wobei der auf die Scheibe IS aufgedampfte Widerstandsfilm WF leitend mit der äußeren Elektrode K1 verbunden ist.

Eine vom Emissionswinkel (Winkel den der Geschwindigkeitsvektor der Sekundärelektronen mit der Strahlachse OA einschließt) unabhängige Energieanalyse der Sekundärelektronen SE ist in einem kugelsymmetrischen Gegenfeld nur dann gewährleistet, wenn dessen Symmetriezentrum mit dem Quellpunkt der Sekundärelektronen zusammenfällt Diese Bedingung ist für das erfindungsgemäße Gegenfeldspektrometer SP sehr gut erfüllt, da der auf der Strahlachse OA liegende gemeinsame Mittelpunkt der halbkugelförmigen Gitterelektroden K1 und K2 wegen des Fehlens der in konventionellen Anordnungen vorhandenen Absaugelektrode sehr nahe an die Probenoberfläche herangebracht werden kann. Aufgrund der geringen Elektrodenspannungen ist hierbei auch die Gefahr eines Überschlages sehr gering.

Zur Meßstellensuche wird ein Oberflächenbereich der hochkomplexen Probe IC üblicherweise mit dem primären Elektronenstrahl PE abgerastert und in bekannter Weise auf dem Sichtgerät des Elektronenstrahlmeßgerätes dargestellt Um eine möglichst große Ablenkung des Primärstrahles zu ermöglichen, besitzen die innere und äußere Elektrode K1 und K2 im Bereich der Strahlachse OA Ausnehmungen, deren Abmessungen größer als der Gitterabstand sind. Wegen der nur schwachen Linsenwirkung der Elektroden K1 und K2 ist außerdem sichergestellt, daß der primäre Elektronenstrahl PE keine Defokussierung im Spektrometer SP erfährt.

Zum Nachweis der Sekundärelektronen SE ist ein unmittelbar oberhalb des Spektrometers SP konzentrisch zur Strahlachse OA angeordneter Detektor DT vorgesehen, der im wesentlichen aus einer ebenen, auf positivem Potential liegenden Gitterelektrode G, einem Szintillator SZ und einer großflächigen, vorzugsweise ringförmig ausgebildeten Photodiode PD besteht. Zum Durchtritt des primären Elektronenstrahls PE sind die genannten Detektorelemente jeweils mit Bohrungen versehen, in die ein konzentrisch zur optischen Achse OA angeordneter Hohlzylinder HZ als Abschirmungen eingelassen ist. Um eine ausreichend hohe Photonenausbeute im Szintillator SZ zu erzeugen, müssen die im Feld der Gitterelektrode G abgesaugten Sekundärelektronen SE auf hohe kinetische Energien beschleunigt werden. Dies wird erreicht, indem man den metallisierten Szintillator SZ auf ein hohes positives Potential von beispielsweise + 10 kV legt Die mit dem Szintillator SZ wechselwirkenden Sekundärelektronen SE regen dessen Moleküle zur Emission kurzer Lichtimpulse an, wobei das im Szintillatorvolumen erzeugte lichtoptische Signal in der Photodiode PD in ein entsprechendes elektrisches Signal umgewandelt und dem Eingang einer in der Fig nicht dargestellten Auswerteelektronik zugeführt wird.

Diese dem Detektor DT nachgeschaltete Auswerteelektronik, die auch den Sekundärelektronenstrom über eine Rückkopplungsschaltung RS durch Nachregeln der Gegenfeldspannung $U_G$ des Spektrometers SP konstant hält ist beispielsweise aus der bereits zitierten Veröffentlichung von H P Feuerbaum bekannt (siehe insbesondere Seite 289, Fig 4)

## Ansprüche

1. Spektrometer-Detektoranordnung für quantitative Potentialmessungen mit einem Gegenfeldspektrometer zur Energieanalyse der von einem entlang einer Strahlachse geführten primären Teilchenstrahl auf einer Probe ausgelösten Sekundärteilchen und einem Detektor zum Nachweis der Sekundärteilchen **gekennzeichnet** durch einen unmittelbar oberhalb des Gegenfeldspektrometers (SP) konzentrisch zur Strahlachse (OA) angeordneten Detektor (DT) der eine auf positivem Potential liegende Elektrode (G) und einen auf einer Photodiode (PD) angeordneten Szintillator (SZ) aufweist, wobei die Elektrode (G), der Szintillator (SZ) und die Photodiode (PD) jeweils Ausnehmungen zum Durchtritt des primären Teilchenstrahls (PE) aufweisen.

2. Spektrometer-Detektoranordnung nach Anspruch 1, dadurch **gekennzeichnet,** daß die Photodiode (PD) ringförmig ausgebildet ist.

3. Spektrometer-Detektoranordnung nach Anspruch 1 oder 2, dadurch **gekennzeichnet,** daß der Detektor (DT) einen konzentrisch zur Strahlachse (OA) angeordneten Hohlzylinder (HZ) als Abschirmung aufweist.

4. Spektrometer-Detektoranordnung nach einem der Ansprüche 1 bis 3, **gekennzeichnet** durch ein Gegenfeldspektrometer (SP) mit einer ersten, auf einem ersten Potential ($U_A$) liegenden halbkugelförmigen Elektrode (K1), mit einer zweiten, auf einem zweiten Potential ($U_G$) liegenden halbkugelförmigen Elektrode (K2), deren Mittelpunkt unmittelbar oberhalb der Probe (IC) auf der Strahlachse (OA) liegt und mit dem Mittelpunkt der ersten Elektrode (K1) zusammenfällt und mit einer ringförmigen Isolatorscheibe (IS), die den Raumbereich zwischen der ersten und zweiten Elektrode (K1, K2) probenseitig abschließt.

5. Spektrometer-Detektoranordnung nach Anspruch 4, dadurch **gekennzeichnet,** daß die Isolatorscheibe (IS) mit einem auf dem zweiten Potential ($U_G$) liegenden Widerstandsfilm (WF) versehen ist.

6. Spektrometer-Detektoranordnung nach einem der Ansprüche 1 bis 5, dadurch **gekennzeichnet,** daß die erste und zweite Elektrode (K1, K2) Gitterelektroden sind und daß die Gitterelektroden im Bereich der Strahlachse (OA) Ausnehmungen aufweisen, deren Abmessungen größer als der mittlere Gitterabstand sind